# EUROPÄISCHE PATENTSCHRIFT

(11) **EP 0 655 516 B1**
(45) Veröffentlichungstag und Bekanntmachung des Hinweises auf die Patenterteilung: **27.11.1996**
(21) Anmeldenummer: 94113922.2
(22) Anmeldetag: 06.09.1994
(51) Int. Cl.: C23C 16/50

(54) **Verfahren zur Beschichtung oder Oberflächenbehandlung von Feststoffteilchen mittels einer Plasma-Wirbelschicht**
Method of coating or surface treatment of solid particles by use of plasma and fluidized bed
Procédé pour le revêtement ou le traitement de la surface de particules solides en lit fluidisé sous plasma

(30) Priorität: 27.11.1993 DE 4340480
(43) Veröffentlichungstag der Anmeldung: 31.05.1995
(73) Patentinhaber: BASF Aktiengesellschaft, 67063 Ludwigshafen (DE)
(72) Erfinder: Harth, Klaus, Dr., D-67317 Altleiningen (DE); Hibst, Hartmut, Dr., D-69198 Schriesheim (DE); Mattmann, Wolfgang, Dr., D-67117 Limburgerhof (DE)

(56) Entgegenhaltungen:
- DATABASE WPI Nr. 75-203 91W; & SU-A-419 368 (VLASOV M.A. et al.) et al.)
- DATABASE WPI Nr. 95-012 086; & JP-A-06 299 146 (MITSU- BISHI CABLE IND. LTD.)
- DERWENT ACCESSION NR. 75-203 91W, Questel Telesystems WIPL; Derwent Publications Ltd., London; & SU-A-419368
- DERWENT ACCESSION Nr. 95-012 086, Questel Telesystems WIPL, Derwent Publications Ltd., London; & JP-A-06 299146

## Beschreibung

Die vorliegende Erfindung betrifft ein verbessertes Verfahren zur Beschichtung oder Oberflächenbehandlung von Feststoffteilchen in einer Wirbelschicht durch Auftragung bzw. Einwirkung eines gasförmigen Beschichtungs- bzw. Behandlungsmittels aus einem Plasma.

Eine Beschichtung von Feststoffteilchen kann sich beispielsweise bei metallischen Magnetpigmenten empfehlen, um eine höhere Korrosionsfestigkeit zu erreichen. Hierzu werden die metallischen Feststoffteilchen mit einer dünnen kohlenstoffhaltigen Schicht überzogen. Auch die Beschichtung von Wirkstoffen stellt ein typisches Anwendungsgebiet dar. Somit kann beispielsweise eine verzögerte Freigabe des Wirkstoffes oder eine verbesserte Haltbarkeit erzielt werden.

Durch eine Oberflächenbehandlung der Feststoffteilchen läßt sich beispielsweise ihre Benetzbarkeit beeinflussen. So kann die Oberfläche von Farbpigmenten durch die Einwirkung von Sauerstoff aufgerauht werden, wodurch das Dispergieren der Farbpigmente erleichtert wird.

Diese Verfahren müssen bestimmte Anforderungen erfüllen, wobei eine gleichmäßige Beschichtung oder Behandlung der Oberfläche der Feststoffteilchen an erster Stelle zu nennen ist. Dabei sind in der Regel nur geringe Schwankungsbreiten zulässig, und entsprechend hoch ist der apparative und verfahrenstechnische Aufwand, um diese und ähnliche Zielvorgaben auf möglichst wirtschaftliche Weise im technischen Betrieb einzuhalten.

Bei einem bekannten Verfahren werden Aluminiumteilchen in einer Wirbelschicht, in die ein Plasmabrenner hineinragt, mit einer kohlenstoffhaltigen Schicht überzogen (T. Kojima et al., Journal De Physique IV, Colloque C2 (1991), "Development Of A Plasma Jetting Fluidized Bed Reactor", Seite 429 bis 436). Hierbei werden Argon als Trägergas und eine Mischung aus Methan und Wasserstoff als Beschichtungsmittel eingesetzt (Seite 430). Das Plasma wird durch einen mit Gleichspannung betriebenen Plasmabrenner erzeugt, der unmittelbar in die Wirbelschicht hineinragt. Durch die Plasmaerzeugung entstehen aus dem Methan Radikale, die eine Radikalkettenreaktion zu größeren organischen Molekülen bewirken, welche ihrerseits letztlich eine vernetzte organische Schicht auf den Aluminiumteilchen bilden. Durch die direkte Einwirkung des Plasmabrenners auf die Wirbelschicht entstehen bei diesem Verfahren jedoch sehr hohe Beschichtungstemperaturen, sodaß lediglich temperaturstabile Substrate wie Metall- oder Keramikpulver beschichtet werden können.

Weiterhin ist ein Verfahren bekannt, bei dem Feststoffteilchen in einem Niederdruckverfahren mit Hilfe einer bei Gleichspannung betriebenen Kaskaden- Lichtbogen-Kerze beschichtet werden (US 4 948 485). Die Beschichtung wird hier dadurch erreicht, daß ein Teilchenstrom an der Lichtbogenkerze vorbeigeführt wird (Spalte 6, Zeilen 8 bis 27). Durch die Druckabsenkung auf Werte unterhalb etwa 0,1 bar (Spalte 2, Zeilen 54 bis 66) kann zwar eine Verringerung der Beschichtungstemperatur erreicht werden, jedoch können die Teilchen nur kurz der Wirkung der Lichtbogenkerze ausgesetzt werden, was die Anwendungsmöglichkeiten dieses Verfahrens stark einschränkt. Weiterhin gestaltet sich bei diesem Verfahren eine gleichmäßige Beschichtung der Teilchen äußerst schwierig.

Die DE-A 36 17 428 beschreibt ein Verfahren, bei dem die Beschichtung von Baustoffen in einer bei Normaldruck betriebenen Wirbelschicht erfolgt, wobei ggf. Wasserstoff mittels eines Plasmabrenners vorgewärmt wird.

Der Erfindung lag daher die Aufgabe zugrunde, den genannten Nachteilen abzuhelfen und ein verbessertes Verfahren zu finden, das auch eine homogene Beschichtung oder Oberflächenbehandlung temperaturempfindlicher Feststoffteilchen ermöglicht, wobei ausreichend lange Verweilzeiten der Feststoffteilchen in dem aktivierten Prozeßgas ermöglicht werden sollen.

Demgemäß wurde ein Verfahren zur Beschichtung von Feststoffteilchen in einer Wirbelschicht durch Auftragung eines gasförmigen Beschichtungsmittels aus einem Plasma gefunden, welches dadurch gekennzeichnet ist, daß man das Plasma außerhalb der Wirbelschicht bei einem Druck von 0,01 bis 500 mbar erzeugt und das plasmaaktivierte Gas in die Wirbelschicht, welche man bei einem Druck von 0,1 bis 500 mbar betreibt, einleitet, wobei man
a. das Plasma aus der Gesamtmenge des gasförmigen Beschichtungsmittels und gegebenenfalls aus einem sonstigen Gas erzeugt oder
b. das Plasma aus einer Teilmenge des gasförmigen Beschichtungsmittels und gegebenenfalls aus einem sonstigen Gas erzeugt und die Restmenge unmittelbar in die Wirbelschicht einführt oder
c. das Plasma aus einem sonstigen Gas erzeugt und die Gesamtmenge des gasförmigen Beschichtungsmittels unmittelbar in die Wirbelschicht einführt.

Außerdem betrifft die Erfindung ein Verfahren zur Oberflächenbehandlung von Feststoffteilchen.

Durch die Plasmaerzeugung wird die notwendige Energie für die Bildung von Radikalen und radikalischen Spaltprodukten eingebracht, die ihrerseits beispielsweise im Falle der Beschichtung letztlich die Bildung einer vernetzten Schicht auf den Feststoffteilchen bewirken. Dabei erfolgt der Beschichtungsvorgang in einer von der Plasmaerzeugung getrennten Wirbelschicht, wodurch die Feststoffteilchen vorteilhafterweise nur relativ niedrigen Temperaturen ausgesetzt werden.

Die Temperaturen bei der Plasmaerzeugung sind üblicherweise sehr hoch, sie können Werte von etwa 1000°C betragen. Durch die Abtrennung der Wirbelschicht von der Plasmaerzeugung und die Druckabsenkung werden die in ihr enthaltenen Feststoffteilchen deutlich niedrigeren Temperaturen ausgesetzt. Dieser Effekt kann in einer bevorzugten Ausführungsform durch Druckabsenkung auf etwa 0,01 bis 100 mbar bei der Plasmaerzeugung und etwa 0,1 bis 100 mbar in der Wirbelschicht weiter verstärkt werden. Es können so Beschichtungen in der Wirbelschicht bei Temperaturen schon ab etwa 20°C durchgeführt werden. Ein bevorzugter Temperaturbereich für das Verfahren erstreckt sich von etwa 20 bis 250°C, besonders bevorzugt 40 bis 200°C. Darüber hinaus ist das Verfahren auch für Anwendungen bei höheren Temperaturen, wie sie bei bekannten plasmaunterstützten Beschichtungsverfahren auftreten, gut geeignet. Die Plasmaerzeugung kann innerhalb einer Teil- oder der Gesamtmenge des gasförmigen Beschichtungsmittels erfolgen. Weiterhin ist es möglich, das Plasma in einem anderen Gas zu erzeugen, welches anschließend getrennt von dem Beschichtungsmittel in die Wirbelschicht geleitet wird und die Radikale auf das Beschichtungsmittel überträgt.

Bei der Oberflächenbehandlung von Feststoffteilchen gilt sinngemäß das gleiche, hierbei wird in Anwesenheit von Behandlungsgasen wie Sauerstoff eine gezielte Veränderung der Oberflächeneigenschaften der Feststoffteilchen erzielt.

Das Verfahren zur Beschichtung von Feststoffteilchen wird im folgenden schematisch näher beschrieben.

Das für das Verfahren benötigte Plasma wird mit Hilfe einer handelsüblichen Vorrichtung gebildet, wobei das zu aktivierende Gas über eine Leitung zugeführt wird. Das Plasma entsteht in der Regel durch Anregung mittels elektromagnetischer Wellen.

In einer bevorzugten Ausführungsform erfolgt die Plasmaerzeugung beispielsweise durch ein Magnetron in einem Frequenzbereich von etwa 0,5 bis 5 GHz, besonders bevorzugt bei 2,45 GHz. Eine besonders effektive und stabile Anregung wird dann erreicht, wenn in einem nachgeschalteten Hohlleiter in an sich bekannter Weise eine stehende Welle gebildet wird. In einer weiteren bevorzugten Anordnung kann die Plasmaerzeugung durch induktive Ankopplung im Innern einer Spule erfolgen. Hierbei empfiehlt sich insbesondere eine Frequenz von etwa 5 kHz bis 50 MHz.

Das aktivierte Gas kann aus dem Beschichtungsmittel oder einem sonstigen Gas bestehen, und es gelangt mittels einer Leitung in den Wirbelschichtreaktor. Über eine Leitung können dem Wirbelschichtreaktor weitere Gase, beispielsweise inerte Trägergase oder Beschichtungsmittel, zugeführt werden. Die Zugabe der unbehandelten Feststoffteilchen erfolgt über eine Leitung. Im Innern des Wirbelschichtreaktors befindet sich oberhalb des Anströmbodens eine Wirbelschicht, die vorwiegend aus den eingesetzten Feststoffteilchen besteht. Durch bekannte konstruktive Maßnahmen, wie beispielsweise eine konische Formgebung des Wirbelschichtreaktors, kann ggf. auf den Anströmboden verzichtet werden. Die durch das Plasma erzeugten Spaltprodukte aus dem Beschichtungsmittel schlagen sich auf den Feststoffteilchen nieder, und die beschichteten Teilchen werden über eine Leitung aus dem Wirbelschichtreaktor entnommen.

Der Gasstrom wird mit der Pumpe durch eine Leitung aus dem Wirbelschichtreaktor abgeführt.

Die Stabilität des Plasmas, die Temperaturbelastung der Partikel sowie die Homogenität und Güte der Beschichtung werden durch die Druck- und Gasflußverhältnisse innerhalb des Plasmas und in der Wirbelschicht beeinflußt. In einer bevorzugten Ausführungsform des Verfahrens liegt der Druck bei der Plasmaerzeugung bei etwa 0,01 bis 100 mbar, besonders bevorzugt bei 1 bis 20 mbar. Dabei empfiehlt sich ein Druck innerhalb der Wirbelschicht von etwa 0,1 bis 100 mbar, besonders 1 bis 20 mbar. Ein größerer Druck kann zu einer starken Temperaturerhöhung in der Plasmaquelle und nachfolgend im Beschichtungsgut innerhalb der Wirbelschicht führen.

Um eine weitere Temperaturabsenkung zu erreichen kann es sich empfehlen, das Gas bei der Plasmaerzeugung zu kühlen. Hierfür können beispielsweise Doppelrohre aus Quarz eingesetzt werden, die mit einem geeigneten gasförmigen oder flüssigen Kühlmedium beaufschlagt werden. Bei der Auswahl des geeigneten Mediums ist neben den vorliegenden Temperaturverhältnissen weiterhin darauf zu achten, daß es ein geringes Absorptionsvermögen für die elektromagnetischen Wellen aufweist. Als Kühlmittel eignet sich beispielsweise Luft.

Dem Wirbelschichtreaktor können mehrere aktivierte und nicht aktivierte Gase zugeführt werden. Hierbei ist es möglich, das Beschichtungsmittel erst im Wirbelschichtreaktor durch Zugabe eines anderen, aktivierten Gases in den Plasmazustand zu überführen.

Die Zufuhr der Gase in den Wirbelschichtreaktor kann variiert werden, es ist eine Zufuhr von oben, seitlich und von unten möglich. Dabei können sich zur Erleichterung der Steuerung mehrere Zuleitungen empfehlen. Zum Aufbau der Wirbelschicht muß allerdings ein entsprechend dimensionierter Gasstrom von unten zugeführt werden.

Das neue Verfahren kann über einen großen Temperaturbereich angewendet werden. Besonders vorteilhaft wird es bei temperaturempfindlichen Produkten angewendet, die zur Wahrung ihrer Qualität keinen allzu hohen Temperaturen ausgesetzt werden dürfen.

Bevorzugte Anwendungsgebiete für das neue Verfahren sind die Beschichtung von Substraten wie Granulaten oder Fasern aus thermo- oder duroplastischen Polymeren, Pigmenten oder Granulaten aus organischen Farbstoffen sowie aus Wirkstoffen. Auch bei der Beschichtung von relativ temperaturstabilen Substraten erweist sich das neue Verfahren als vorteilhaft, da durch die niedrigen Temperaturen und Drücke eine höhere Wirtschaftlichkeit und Prozeßsicherheit erreicht werden kann. Geeignete Anwendungsgebiete sind beispielsweise bei der Beschichtung von Pulvern aus metallischen oder keramischen Werkstoffen, anorganischen Farb- und Magnetpigmenten, mineralischen Füllstoffen, Fasern aus Glas oder Kohlenstoff, Düngemittelteilchen oder Katalysatorträgern zu finden.

Die Anwendung des Verfahrens kann sich beispielsweise empfehlen, um die Oberflächeneigenschaften der Feststoffteilchen so zu verändern, daß ihre nachfolgende Weiterverarbeitung erleichtert wird, wie es bei Füllstoffen für Kunststoffe der Fall sein kann. Auch die Beschichtung von Feststoffteilchen mit Effektschichten ist ein typisches Anwendungsgebiet, wodurch beispielsweise die optischen, magnetischen oder katalytischen Eigenschaften beeinflußt werden können.

Das eingesetzte Beschichtungsmittel richtet sich nach der gewünschten Beschichtungsart. Als Beschichtungsmittel eignen sich prinzipiell alle organischen Verbindungen, die unter den Reaktionsbedingungen gasförmig sind, darunter besonders gesättigte und ungesättigte Kohlenwasserstoffe mit bis zu 8 C-Atomen wie Methan, Ethan, Propan, Butan, Isobutan, Hexan, Cyclohexan, Octan, Ethylen, Propylen, But-1-en, But-2-en und Butadien. Ansonsten kommen z. B. C₁- bis C₄-Alkanole, Siliciumwasserstoffe, siliciumorganische Verbindungen wie Hexamethyldisiloxan und metallorganische Verbindungen wie Metallcarbonyle, Metallalkyle sowie Titanamide in Betracht, sowie Gemische dieser und weiterer Verbindungen.

Bei der Plasmaerzeugung bilden die gasförmigen Beschichtungsmittel Radikale, welche beim Beschichtungsvorgang im Wirbelbett Radikalkettenreaktionen auslösen. Aus den Radikalen entsteht auf der Oberfläche der zu beschichtenden Teilchen letztlich eine zusammenhängende vernetzte Schicht. Gemäß den drei Ausführungsformen (a) bis (c) kann man die Gesamtmenge des Beschichtungsmittels dem Wirbelbett über die plasmaerzeugende Vorrichtung zuführen, wobei man auch sonstige Gase wie Stickstoff, Sauerstoff oder Edelgase, z. B. Neon oder Argon, mitverwenden kann. Wesentlich ist letztlich aber nur, daß im Plasma eine bestimmte Anzahl von Radikalen beliebiger Atome oder Moleküle erzeugt wird, die dann in das Wirbelbett gelangt und die Kettenreaktion mit der Rest- oder Gesamtmenge des Beschichtungsmittels auslöst, die man unmittelbar in das Wirbelbett einführen kann.

Für das Verfahren zur Oberflächenbehandlung von Feststoffteilchen gilt sinngemäß das gleiche, allerdings werden hierbei in der Regel andere Gase wie Sauerstoff, Stickstoff und/oder Edelgase verwendet. Weiterhin haben sich Gase als geeignet erwiesen, welche Sauerstoff und/oder Stickstoff in gebundener Form enthalten. Durch die Einwirkung von Sauerstoff kann beispielsweise ein Aufrauhen der Oberfläche der Feststoffteilchen bewirkt werden, was ein späteres Benetzen mit anderen Materialien erleichtern kann.

In einer bevorzugten Ausführungsform wird der Druck bei der Plasmaerzeugung auf ca. 0,01 bis 100 mbar und in der Wirbelschicht auf Werte zwischen ca. 0,1 und 100 mbar reduziert. Somit kann eine Oberflächenbehandlung bereits bei Temperaturen ab etwa 20°C erfolgen.

Das erfindungsgemäße Verfahren zur Beschichtung oder Oberflächenbehandlung von Feststoffteilchen kann wegen der Trennung von Plasmaerzeugung und Wirbelschicht bei niedrigen Temperaturen durchgeführt werden. Daher können bei diesem Verfahren auch relativ temperaturempfindliche Substrate eingesetzt werden.

Auch bei temperaturstabileren Substraten erweist sich das neue Verfahren als vorteilhaft, da durch die niedrigen Temperaturen eine höhere Wirtschaftlichkeit und Prozeßsicherheit erzielt werden kann.

Da die Beschichtung der Feststoffteilchen in einer Wirbelschicht erfolgt, ist die Verweilzeit der Feststoffteilchen über einen großen Bereich einstellbar und darüber hinaus eine schonende Behandlung gewährleistet.

### Beispiel

### Herstellung eines Verapamil-Retardpräparates

In einem konischen Laborreaktor von etwa 200 mm Höhe und einem Durchmesser von 10 bis 26 mm wurden etwa 1 mm große Feststoffteilchen aus dem Arzneimittelwirkstoff Verapamil (alpha-Isopropyl-alpha-((N-methyl-N-homoveratryl)-gamma-aminopropyl)-3,4-dimethoxyphenylacetonitril-Hydrochlorid) vorgelegt. Insgesamt wurden etwa 3 g an Feststoffteilchen zugegeben.

Der Reaktor wurde bei einer Temperatur von etwa 80°C und einem Druck von ca. 2 bis 3 mbar betrieben. Von unten wurde in den Reaktor plasmaaktiviertes Argon, welches durch Mikrowellen erzeugt wurde, eingeleitet, von oben wurde Ethylen zugegeben. Dabei betrugen die Volumenströme unter Normbedingungen etwa 730 ml/min an Argon und 1650 ml/min an Ethylen. Die Versuchsdauer betrug 30 Minuten.

Die Feststoffteilchen wurden während des Versuches mit einer Polymerschicht überzogen. Zur Bestimmung der Retardwirkung wurde die Freisetzungsrate mit Hilfe des Paddle-Modells nach USP XXII (United States Pharmacopoeia) bestimmt. Diese Methode besteht im wesentlichen darin, die erfindungsgemäßen Feststoffteilchen in einer sauren Lösung unter Rühren aufzulösen. Durch Konzentrationsmessungen in entnommenen Proben wird der Anteil des gelösten Wirkstoffs in Abhängigkeit von der Zeit bestimmt. Hierbei ergaben sich folgende Werte:

| Zeit [min] | Freisetzung [%] |
|---|---|
| 20 | 53 |
| 40 | 90,6 |
| 60 | 96,5 |
| 120 | 98,5 |
| 180 | 100 |
| 240 | 100 |

## Patentansprüche

1. Verfahren zur Beschichtung von Feststoffteilchen in einer Wirbelschicht durch Auftragung eines gasförmigen Beschichtungsmittels aus einem Plasma, dadurch gekennzeichnet, daß man das Plasma außerhalb der Wirbelschicht bei einem Druck von 0,01 bis 500 mbar erzeugt und das plasmaaktivierte Gas in die Wirbelschicht, welche man bei einem Druck von 0,1 bis 500 mbar betreibt, einleitet, wobei man
a. das Plasma aus der Gesamtmenge des gasförmigen Beschichtungsmittels und gegebenenfalls aus einem sonstigen Gas erzeugt oder
b. das Plasma aus einer Teilmenge des gasförmigen Beschichtungsmittels und gegebenenfalls aus einem sonstigen Gas erzeugt und die Restmenge unmittelbar in die Wirbelschicht einführt oder
c. das Plasma aus einem sonstigen Gas erzeugt und die Gesamtmenge des gasförmigen Beschichtungsmittels unmittelbar in die Wirbelschicht einführt.

2. Verfahren nach Anspruch 1, dadurch gekennzeichnet, daß das gasförmige Beschichtungsmittel Kohlenwasserstoffe, Alkanole, Siliciumwasserstoffe, siliciumorganische und/oder metallorganische Verbindungen enthält.

3. Verfahren zur Oberflächenbehandlung von Feststoffteilchen in einer Wirbelschicht durch Einwirkung eines gasförmigen Behandlungsmittels aus einem Plasma, dadurch gekennzeichnet, daß man das Plasma außerhalb der Wirbelschicht bei einem Druck von 0,01 bis 500 mbar erzeugt und das plasmaaktivierte Gas in die Wirbelschicht, welche man bei einem Druck von 0,1 bis 500 mbar betreibt, einleitet, wobei man
a. das Plasma aus der Gesamtmenge des gasförmigen Behandlungsmittels und gegebenenfalls aus einem sonstigen Gas erzeugt oder
b. das Plasma aus einer Teilmenge des gasförmigen Behandlungsmittels und gegebenenfalls aus einem sonstigen Gas erzeugt und die Restmenge unmittelbar in die Wirbelschicht einführt oder
c. das Plasma aus einem sonstigen Gas erzeugt und die Gesamtmenge des gasförmigen Behandlungsmittels unmittelbar in die Wirbelschicht einführt.

4. Verfahren nach Anspruch 3, dadurch gekennzeichnet, daß das gasförmige Behandlungsmittel Sauerstoff und/oder eine sauerstoffhaltige Verbindung, Stickstoff und/oder eine stickstoffhaltige Verbindung und/oder ein Edelgas enthält.

5. Verfahren nach den Ansprüchen 1 bis 4, dadurch gekennzeichnet, daß die Plasmaerzeugung mittels einer Wechselspannung mit einer Frequenz zwischen 5 kHz und 5 GHz erfolgt.

6. Verfahren nach den Ansprüchen 1 bis 5, dadurch gekennzeichnet, daß man die Plasmaerzeugung des Behandlungs- oder Beschichtungsmittels in einem Druckbereich zwischen 0,01 und 100 mbar und die Wirbelschicht in einem Druckbereich zwischen 0,1 und 100 mbar betreibt.

## Claims

1. A process for coating solid particles in a fluidized bed by application of a gaseous coating agent from a plasma, wherein the plasma is generated outside the fluidized bed under a pressure of from 0.01 to 500 mbar, and the plasma-activated gas is passed into the fluidized bed, which is operated under a pressure of from 0.1 to 500 mbar, where
a. the plasma is generated from the total amount of gaseous coating agent with or without another gas, or
b. the plasma is generated from a portion of the gaseous coating agent with or without another gas, and the remaining portion is introduced directly into the fluidized bed, or
c. the plasma is generated from another gas, and the total amount of gaseous coating agent is introduced directly into the fluidized bed.

2. A process as claimed in claim 1, wherein the gaseous coating agent contains hydrocarbons, alkanols, silanes, organosilicon and/or organometallic compounds.

3. A process for the surface treatment of solid particles in a fluidized bed by the action of a gaseous treating agent from a plasma, wherein the plasma is generated outside the fluidized bed under a pressure of from 0.01 to 500 mbar, and the plasma-activated gas is passed into the fluidized bed, which is operated under a pressure of from 0.1 to 500 mbar, where
a. the plasma is generated from the total amount of gaseous treating agent with or without another gas, or
b. the plasma is generated from a portion of the gaseous treating agent with or without another gas, and the remaining portion is introduced directly into the fluidized bed, or
c. the plasma is generated from another gas, and the total amount of gaseous treating agent is introduced directly into the fluidized bed.

4. A process as claimed in claim 3, wherein the gaseous treating agent contains oxygen and/or an oxygen-containing compound, nitrogen and/or a nitrogen-containing compound and/or a noble gas.

5. A process as claimed in claims 1 to 4, wherein the plasma is generated by means of an alternating voltage with a frequency of from 5 kHz to 5 GHz.

6. A process as claimed in claims 1 to 5, wherein the plasma of the treating or coating agent is generated at a pressure in the range from 0.01 to 100 mbar, and the fluidized bed is operated at a pressure in the range from 0.1 to 100 mbar.

## Revendications

1. Procédé de revêtement de particules solides dans une couche tourbillonnaire par application d'un agent de revêtement gazeux constitué d'un plasma, caractérisé par le fait qu'on produit le plasma à l'extérieur de la couche tourbillonnaire à une pression de 0,01 à 500 mbar et introduit le gaz activé au plasma dans la couche tourbillonnaire, qu'on active à une pression de 0,1 à 500 mbar, et on
a. produit le plasma à partir de la totalité de l'agent de revêtement gazeux et éventuellement d'un autre gaz ou
b. produit le plasma à partir d'une partie de l'agent de revêtement gazeux et éventuellement d'un autre gaz et introduit le reste directement dans la couche tourbillonnaire ou
c. produit le plasma à partir d'un autre gaz et introduit la totalité de l'agent de revêtement gazeux directement dans la couche tourbillonnaire.

2. Procédé selon la revendication 1, caractérisé par le fait que l'agent de revêtement gazeux contient des hydrocarbures, des alcanols, des silanes, des composés organosiliciques et/ou organométalliques.

3. Procédé de traitement de surface de particules solides dans une couche tourbillonnaire par action d'un agent de traitement gazeux constitué d'un plasma, caractérisé par le fait qu'on produit le plasma à l'extérieur de la couche tourbillonnaire à une pression de 0,01 à 500 mbar et introduit le gaz activé au plasma dans la couche tourbillonnaire, qu'on active à une pression de 0,1 à 500 mbar, et on
a. produit le plasma à partir de la totalité de l'agent de traitement gazeux et éventuellement d'un autre gaz ou
b. produit le plasma à partir d'une partie de l'agent de traitement gazeux et éventuellement d'un autre gaz et introduit le reste directement dans la couche tourbillonnaire ou
c. produit le plasma à partir d'un autre gaz et introduit la totalité de l'agent de traitement gazeux directement dans la couche tourbillonnaire.

4. Procédé selon la revendication 3, caractérisé par le fait que l'agent de traitement gazeux contient de l'oxygène et/ou un composé contenant de l'oxygène, de l'azote et/ou un composé contenant de l'azote et/ou un gaz rare.

5. Procédé selon les revendications 1 à 4, caractérisé par le fait que le plasma est produit au moyen d'une tension alternative de fréquence comprise entre 5 kHz et 5 GHz.

6. Procédé selon les revendications 1 à 5, caractérisé par le fait qu'on active la production de plasma de l'agent de traitement ou de revêtement dans un domaine de pression compris entre 0,01 et 100 mbar et la couche tourbillonnaire dans un domaine de pression compris entre 0,1 et 100 mbar.
